(19) **Europäisches Patentamt / European Patent Office / Office européen des brevets**

(11) **EP 2 830 215 B1**

(12) **FASCICULE DE BREVET EUROPEEN**

(45) Date de publication et mention
de la délivrance du brevet:
**23.03.2016 Bulletin 2016/12**

(51) Int Cl.:
**H03F 3/45** *(2006.01)* **H03F 3/70** *(2006.01)*

(21) Numéro de dépôt: **14177811.8**

(22) Date de dépôt: **21.07.2014**

(54) **Preamplificateur de charge**

Ladungsvorverstärker

Load preamplifier

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **24.07.2013 FR 1357291**

(43) Date de publication de la demande:
**28.01.2015 Bulletin 2015/05**

(73) Titulaire: **COMMISSARIAT A L'ENERGIE ATOMIQUE ET AUX ENERGIES ALTERNATIVES 75015 Paris (FR)**

(72) Inventeurs:
• **Lugiez, Francis**
**92220 BAGNEUX (FR)**
• **Gevin, Olivier**
**91120 PALAISEAU (FR)**

(74) Mandataire: **Lebkiri, Alexandre Cabinet Camus Lebkiri 25, Rue de Maubeuge 75009 Paris (FR)**

(56) Documents cités:
EP-A2- 1 460 402    US-A- 4 760 345
US-A- 5 523 642    US-A1- 2013 161 492

**Description**

**DOMAINE TECHNIQUE DE L'INVENTION**

Le domaine technique de l'invention est celui des capteurs source de charge. La présente invention concerne un préamplificateur de charge pour convertir une charge électrique générée dans un capteur source de charge en un signal de tension.

**ARRIERE PLAN TECHNOLOGIQUE DE L'INVENTION**

Un capteur est généralement suivi d'un conditionneur assurant la conversion de la grandeur électrique en sortie du capteur en une grandeur électrique exploitable, généralement une tension. Dans le cas de mesures physiques à l'aide d'un capteur délivrant une charge électrique sous l'effet d'un signal à mesurer, aussi appelé « capteur source de charge », tel un capteur piézoélectrique, le conditionneur approprié est un préamplificateur de charge.

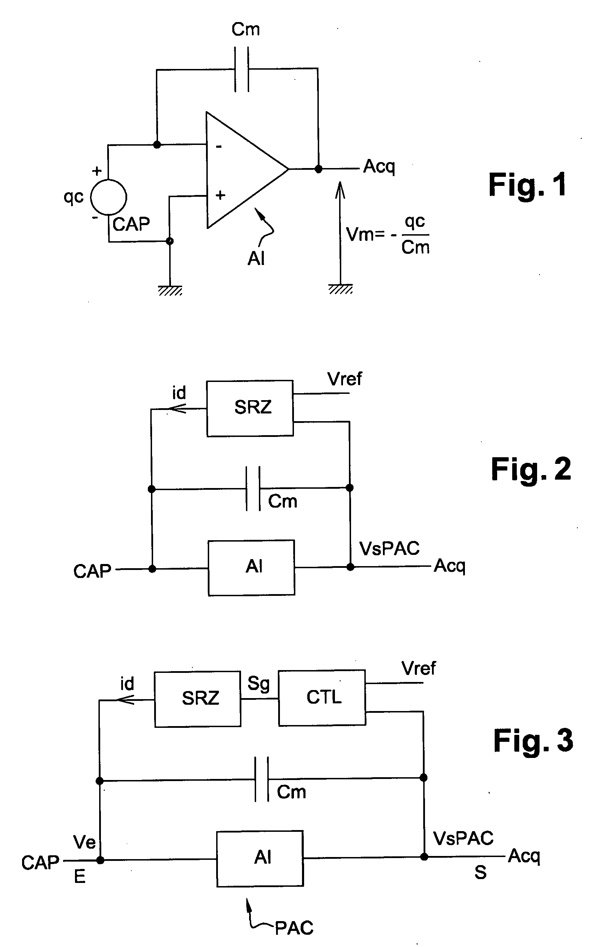

En référence à la figure 1, un préamplificateur de charge comporte un amplificateur inverseur de phase AI, ici de type opérationnel, et un condensateur $C_m$, appelé « condensateur mémoire », collectant la charge délivrée par le capteur CAP. Le capteur CAP est représenté par une source de charge $q_c$. Plus précisément, l'amplificateur opérationnel AI comporte une borne d'entrée inversée reliée à une sortie du capteur CAP, et une borne d'entrée non inverseuse reliée à une tension de référence. Le condensateur mémoire $C_m$ est placé entre la borne d'entrée inverseuse et la borne de sortie de l'amplificateur opérationnel AI. On note que l'amplificateur inverseur de phase AI pourrait également être de type transconductance. La mesure de la tension aux bornes du condensateur mémoire $C_m$ est proportionnelle à la quantité de charge $q_c$ générée par le capteur CAP, et indépendante de la capacité du capteur CAP et des câbles de liaison.

La décharge, aussi appelée « remise à zéro », du condensateur mémoire stockant la charge électrique délivrée par le capteur, peut s'effectuer de façon permanente ou de façon impulsionnelle, périodique ou non, à l'aide d'un système de remise à zéro placé dans une boucle de contre-réaction de l'amplificateur de charge. On note qu'il importe d'éviter la saturation de l'amplificateur opérationnel et de maintenir une dynamique de mesure suffisante.

Dans le cas d'une remise à zéro permanente, il est connu d'utiliser un système de remise à zéro comportant une résistance placée en parallèle du condensateur mémoire, permettant la décharge du condensateur mémoire. La valeur de la résistance doit être choisie très élevée pour réduire le bruit qu'elle apporte. En effet, le capteur a généralement un courant de fuite $I_{det}$ dépendant de paramètres tels que la température, les conditions de polarisation électrique du capteur, les doses d'irradiation reçues, etc. Ce courant de fuite génère un bruit de grenaille de variance $2qI_{det}$, où q est la charge élémentaire d'un électron. Si la résistance a une valeur égale à $2kT/(q.I_{det})$, soit 52MOhms pour 1nA, la puissance du bruit de grenaille est doublée.

Or une résistance de cet ordre de grandeur n'est pas réalisable sous forme de pure résistance passive pour des raisons dimensionnelles inadaptées aux circuits intégrés. En référence à la figure 2, on utilise classiquement des composants actifs SRZ polarisés à de très faibles courants, pour remplacer la résistance. Le composant actif SRZ génère un courant de décharge $i_d$ contrôlé par les variations de la tension de sortie $V_{sPAC}$ de l'amplificateur opérationnel AI. Dans le mode de réalisation de la figure 2, le composant actif SRZ est un transistor MOS, équivalent à un générateur de courant contrôlé en tension. Le courant de décharge $i_d$ est contrôlé par l'écart entre la tension de sortie $V_{sPAC}$ et une valeur de référence $V_{ref}$, correspondant à la tension de sortie au repos du préamplificateur de charge. Le courant de décharge $i_d$ délivré par le composant actif SRZ apporte au condensateur mémoire $C_m$ une charge opposée à la charge générée par le signal et stockée dans le condensateur mémoire $C_m$.

Cependant, l'élément actif ajoute des bruits à la mesure. En effet, le bruit d'un élément actif dépend directement du courant qui le traverse. En fonctionnement statique, c'est-à-dire en l'absence de signal, ces bruits dépendent des courants de polarisation de l'élément actif, qui sont minimalisés pour limiter la source de bruit. Mais en fonctionnement dynamique, c'est-à-dire après l'arrivée d'un signal, dès que la charge électrique correspondant au signal a commencé à être stockée sur le condensateur mémoire, le composant actif est activé et le courant de décharge qu'il fournit en entrée du préamplificateur de charge augmente. Ce courant de décharge atteint une valeur maximale sensiblement en même temps que la charge stockée dans le condensateur mémoire, éventuellement légèrement plus tard si le chemin électrique correspondant est plus lent que le circuit de charge du condensateur mémoire. Le courant traversant l'élément actif passe donc d'une valeur de repos faible à une valeur beaucoup plus grande nécessaire pour décharger le condensateur mémoire. Ce courant transitoire est source de bruit dont la variance croît avec l'amplitude dudit courant. On peut ainsi réaliser un système de remise à zéro peu bruyant en l'absence de signal, mais il n'est pas possible de maintenir cette propriété lors de la mesure d'un signal.

Or ce bruit induit une fluctuation supplémentaire sur la mesure du signal et cette fluctuation est d'autant plus importante que le maximum de courant de décharge est proche de l'instant d'arrivée du signal à l'entrée de l'amplificateur de charge.

Les documents US 476 035 et US 5523642 comprennent des exemples d'amplicateurs de charge.

## DESCRIPTION GENERALE DE L'INVENTION

L'invention propose un préamplificateur de charge permettant de limiter ce bruit.

Selon un premier aspect, l'invention concerne essentiellement un préamplificateur de charge pour convertir une charge électrique générée dans un capteur source de charge en un signal de tension, comportant :

- un amplificateur inverseur de phase comportant une entrée liée au capteur source de charge,
- un condensateur mémoire connecté entre l'entrée et une sortie de l'amplificateur inverseur de phase,
- un système de remise à zéro connecté à l'entrée de l'amplificateur inverseur de phase, pour fournir au condensateur mémoire un courant de décharge en fonction d'un signal de contrôle.

En outre, le préamplificateur de charge comporte un élément de contrôle connecté entre le système de remise à zéro et la sortie de l'amplificateur inverseur de phase, et adapté pour fournir le signal de contrôle au système de remise à zéro, ledit signal de contrôle étant proportionnel à l'écart entre la tension de sortie de l'amplificateur inverseur de phase et une tension de référence, ledit coefficient de proportionnalité étant inférieur à un pour des hautes fréquences.

En d'autres termes, l'élément de contrôle comporte :

- une première entrée connectée à la sortie de l'amplificateur inverseur de phase, pour prélever le signal de tension
- une deuxième entrée soumise à une tension de référence
- un ensemble de composants configurés et agencés pour générer un signal de contrôle proportionnel à l'écart entre le signal de tension et la tension de référence, ledit coefficient de proportionnalité étant inférieur à un dans une bande de hautes fréquences
- une sortie connectée au système de remise à zéro pour lui fournir le signal de contrôle.

On entend par « le signal de contrôle est proportionnel à l'écart entre le signal de tension et la tension de référence, ledit coefficient de proportionnalité étant inférieur à un dans une bande de hautes fréquences » que le signal de contrôle est tel que :

$$Sg = \alpha\,(VsPAC - Vref)$$

Où :

- Sg est le signal de contrôle
- $V_{sPAC}$ est le signal de tension
- Vref est la tension de référence
- $\alpha$ est un coefficient de proportionnalité dépendant de la fréquence
- $\alpha < 1$ dans une bande de hautes fréquences

En d'autres termes, l'élément de contrôle se comporte comme un atténuateur de la différence entre le signal de tension et la tension de référence dans une bande de hautes fréquences.

Outre les caractéristiques principales qui viennent d'être mentionnées dans le paragraphe précédent, le dispositif selon l'invention peut présenter une ou plusieurs caractéristiques complémentaires parmi les suivantes, considérées individuellement ou selon les combinaisons techniquement possibles :

- le coefficient de proportionnalité est supérieur à un pour des basses fréquences. En d'autres termes, l'élément de contrôle se comporte comme un amplificateur de la différence entre le signal de tension et la tension de référence en basses fréquences.

- l'élément de contrôle comporte un amplificateur à transconductance modifié comportant :

  ◦ un élément résistif
  ◦ un premier transistor à effet de champ d'un premier type, la grille et le drain du premier transistor étant reliés
  ◦ un deuxième transistor à effet de champ de même type que le premier transistor, les sources du premier transistor et du deuxième transistor étant à un même potentiel fixe, les grilles du premier transistor et du deuxième transistor étant connectées via l'élément résistif
  ◦ un condensateur connecté entre la grille et le drain du deuxième transistor

- l'élément résistif comporte un deuxième amplificateur à transconductance, polarisé par un courant faible
- l'élément de contrôle comporte :

  ◦ une source de courant continu
  ◦ un troisième transistor à effet de champ de type complémentaire au premier transistor, tel que :

  ▪ le drain du troisième transistor est connecté au drain du premier transistor
  ▪ la source du troisième transistor est connectée à la source de courant
  ▪ la grille du troisième transistor est soumise à la tension de sortie de l'amplificateur inverseur de phase

  ◦ un quatrième transistor à effet de champ de type complémentaire au premier transistor, tel que :

  ▪ le drain du quatrième transistor est connecté au drain du deuxième transistor
  ▪ la source du troisième transistor est connectée à la source de courant
  ▪ la grille du troisième est soumise à la tension de référence

- l'élément de contrôle comporte :

  ◦ un amplificateur opérationnel, comportant :

  ▪ une borne non inverseuse soumise au signal de tension
  ▪ une borne inverseuse soumise à la tension de référence
  ▪ une sortie reliée à un réseau passif

  ◦ le réseau passif comportant :

  ▪ une première résistance, comportant une première borne connectée à la sortie de l'amplificateur opérationnel, et une deuxième borne au niveau de laquelle est prélevé le signal de tension
  ▪ une deuxième résistance, comportant une première borne connectée à la deuxième borne de la première résistance, et une deuxième borne
  ▪ une troisième résistance comprenant une première borne connectée à la deuxième borne de la deuxième résistance, et une deuxième borne soumise à une tension nulle
  ▪ un deuxième condensateur, monté en parallèle de la deuxième résistance.

- le système de remise à zéro comporte un transistor à effet de champ dont la source est soumise au signal de contrôle
- le système de remise à zéro comporte un transistor bipolaire dont l'émetteur est soumis au signal de contrôle
- le système de remise à zéro est polarisé par un courant de fuite du capteur.

On entend par « type » de transistor, un transistor à canal N ou à canal P. Un transistor à canal N et un transistor à canal P sont dits de type complémentaire.

L'invention et ses différentes applications seront mieux comprises à la lecture de la description qui suit et à l'examen des figures qui l'accompagnent.

**BREVE DESCRIPTION DES FIGURES**

Les figures ne sont présentées qu'à titre indicatif et nullement limitatif de l'invention.

Les figures montrent :

- à la figure 1, déjà décrite, un préamplificateur de charge selon l'art antérieur
- à la figure 2, déjà décrite, un préamplificateur de charge avec une fonction de remise à zéro selon l'art antérieur
- à la figure 3, un préamplificateur de charge avec une fonction de remise à zéro, selon un mode de réalisation de l'invention
- à la figure 4, un système de contrôle et un élément de contrôle assurant une fonction de remise à zéro, selon un premier mode de réalisation de l'invention
- à la figure 5, un diagramme de Bode de l'élément de contrôle de la figure 4
- à la figure 6, un élément de contrôle selon un deuxième mode de réalisation de l'invention
- à la figure 7, un diagramme de Bode de l'élément de contrôle de la figure 6.

**DESCRIPTION DETAILLEE D'AU MOINS UN MODE DE REALISATION DE L'INVENTION**

La figure 3 montre un préamplificateur de charge PAC selon un mode de réalisation de l'invention. Le préamplificateur de charge PAC comporte une entrée E connectée à une sortie d'un capteur CAP source de charge, et une sortie S connectée à un dispositif d'acquisition ACQ de tension.

Le préamplificateur de charge PAC comporte :

- un amplificateur inverseur de phase AI

  ◦ une entrée liée à l'entrée E du préamplificateur de charge PAC, c'est-à-dire liée au capteur CAP source de charge
  ◦ une sortie liée à la sortie S du préamplificateur de charge PAC, c'est-à-dire liée au dispositif d'acquisition ACQ de tension, pour fournir un signal de tension $V_{sPAC}$

- un condensateur mémoire $C_m$

  ◦ une première borne connectée à l'entrée E du préamplificateur de charge PAC
  ◦ une deuxième borne connectée à la sortie S du préamplificateur de charge PAC

- un système de remise à zéro SRZ

  ◦ une sortie connectée à l'entrée E du préamplificateur de charge PAC,
  ◦ une entrée connectée à un élément de contrôle CTL

- l'élément de contrôle CTL comportant :

  ◦ une sortie connectée à l'entrée du système de remise à zéro SRZ pour lui fournir un signal de contrôle Sg
  ◦ une première entrée connectée à la sortie S du préamplificateur de charge PAC, pour prélever le signal de tension $V_{sPAC}$
  ◦ une deuxième entrée soumise à une tension de référence $V_{ref}$

Tel que décrit précédemment, l'amplificateur inverseur de phase AI est de type opérationnel (voir figure 1) ou bien de type transconductance. Le condensateur mémoire Cm, connecté en contre-réaction entre l'entrée E et la sortie S de l'amplificateur inverseur de phase, forme un intégrateur de Miller. Le système de remise à zéro SRZ fournit un courant de décharge $i_d$ au condensateur mémoire $C_m$. Dans un mode de réalisation, le système de remise à zéro SRZ est réalisé à l'aide de transistors. Enfin, l'élément de contrôle CTL régule la tension de sortie $V_{sPAC}$ de l'amplificateur inverseur de phase AI à la tension de référence $V_{ref}$.

L'élément de contrôle CTL comporte un ensemble de composants configurés et agencés pour générer un signal de contrôle Sg qui soit proportionnel à l'écart entre le signal de tension $V_{sPAC}$ et la tension de référence, le coefficient de proportionnalité étant dépendant de la fréquence et étant inférieur à un dans une bande de hautes fréquences. Avantageusement, le coefficient de proportionnalité est en outre supérieur à un en basses fréquences.

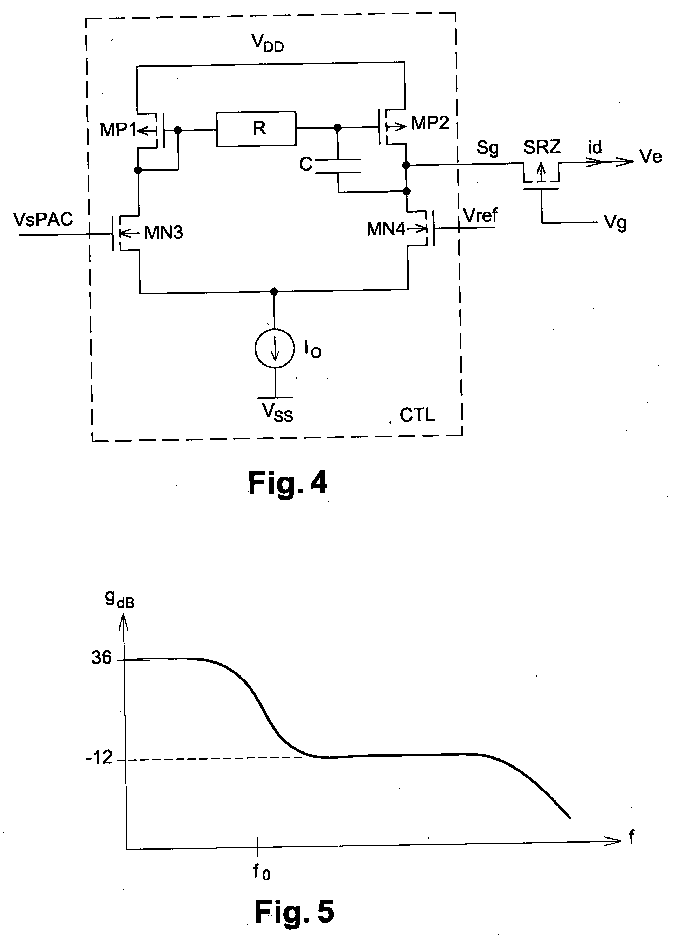

La figure 4 montre un premier mode de réalisation d'un système de remise à zéro SRZ et d'un élément de contrôle CTL selon l'invention.

Le système de remise à zéro SRZ est dans le cas présent un transistor MOSFET canal P, monté en grille commune. Dans un autre mode de réalisation, le système de remise SRZ à zéro est un transistor MOSFET, canal P ou canal N, monté en source commune. Dans un autre mode de réalisation, le système de remise à zéro SRZ est un transistor bipolaire NPN ou PNP, monté en émetteur commun. Dans un autre mode de réalisation, le système de remise à zéro SRZ est un transistor bipolaire NPN ou PNP, monté en base commune. Dans un mode de réalisation décrit, le système de remise à zéro SRZ est polarisé par le courant de fuite du capteur CAP, présent en entrée du préamplificateur de charge PAC. Dans un autre mode de réalisation, le système de remise à zéro SRZ est polarisé par une source de courant dédiée.

Le système de remise à zéro SRZ fournit un courant de décharge $i_d$ contrôlé par un signal de contrôle Sg fourni par l'élément de contrôle CTL.

Dans le mode de réalisation de la figure 4, l'élément de contrôle CTL est un amplificateur à transconductance modifié à l'aide d'un réseau résistance-capacité. Plus précisément, l'amplificateur à transconductance comporte :

- une source de courant continu $I_o$
- un premier transistor MP1 à effet de champ à canal P

- un deuxième transistor MP2 à effet de champ à canal P
- un troisième transistor MN3 à effet de champ à canal N
- un quatrième transistor MN4 à effet de champ à canal N
- un élément résistif R
- un condensateur C.

Il est évident que le fonctionnement ne serait pas modifié si on choisissait les transistors différemment. En effet, le premier transistor MP1 et le deuxième transistor MP2 pourraient être de type à canal N ; le troisième transistor MN3 et le quatrième transistor MN4 seraient alors de type à canal P. Il suffit en effet que les deux groupes de transistors soient de type complémentaire.

Le premier transistor MP1 et le deuxième transistor MP2 sont montés en miroir de courant modifié :

- la grille et le drain du premier transistor MP1 sont connectés
- la source du premier transistor MP1 et la source du deuxième transistor MP2 sont à un même potentiel fixe $V_{DD}$
- la grille du premier transistor MP1 et la grille du deuxième transistor MP2 sont reliées par l'intermédiaire de l'élément résistif R. On note que l'élément résistif R isole le premier transistor MP1 du second transistor MP2, alors qu'ils sont reliés dans un montage en miroir de courant classique.
- le drain du premier transistor MP1 est connecté à la source de courant par l'intermédiaire du troisième transistor MN3
- le drain du deuxième transistor MP2 est connecté à la source de courant par l'intermédiaire du quatrième transistor MN4.
- la grille et le drain du deuxième transistor MP2 sont connectés par l'intermédiaire du condensateur C.

Plus précisément :

- le drain du troisième transistor MN3 est connecté au drain du premier transistor MP1
- la source du troisième transistor MN3 est connectée à la source de courant $I_0$
- le drain du quatrième transistor MN4 est connecté au drain du deuxième transistor MP2
- la source du quatrième transistor MN4 est connectée à la source de courant $I_0$.

De plus :

- la grille du troisième transistor MN3 est soumise à la tension de sortie $V_{sPAC}$ de l'amplificateur inverseur de phase AI
- la grille du troisième transistor MN3 est soumise à la tension de référence $V_{ref}$.

Ainsi, la tension en sortie de l'amplificateur à transconductance est proportionnelle à l'écart entre la tension de sortie $V_{sPAC}$ de l'amplificateur inverseur de phase AI, et la tension de référence $V_{ref}$. La tension en sortie de l'amplificateur à transconductance est le signal de contrôle Sg appliqué au système de remise à zéro SRZ. Mais le coefficient de proportionnalité varie en fonction de la fréquence, comme le montre le diagramme en gain de Bode de l'élément de contrôle CTL, représenté à la figure 5.

En basses fréquences, c'est-à-dire en régime statique, c'est-à-dire en l'absence de détection, le gain $g_{dB}$ de l'élément de contrôle est élevé. Dans le cas présent, il est de 36 décibels. Puis, à partir d'une certaine fréquence $f_0$, le gain $g_{dB}$ chute avant de se rétablir à une valeur inférieure à un, dans le cas présent -12 décibels. L'élément de contrôle CTL se comporte donc comme un amplificateur en basses fréquences, et comme un atténuateur dans une bande de fréquences plus élevées.

En effet, en basses fréquences, le condensateur C est équivalent à un circuit ouvert, tandis qu'en hautes fréquences, le condensateur C est équivalent à un circuit fermé. En hautes fréquences, la grille et le drain du deuxième transistor MP2 sont donc au même potentiel. Le deuxième transistor MP2 se comporte alors comme une résistance de charge de valeur connue et maîtrisable en fixant le courant $I_0$ débité par la source de courant.

On note qu'à partir d'une certaine fréquence, le gain chute à nouveau : cela est dû à la présence de capacités parasites non représentées sur la figure et aux limites de mobilité des porteurs de charge dans les matériaux des transistors.

Le comportement d'amplificateur et d'atténuateur en fonction des fréquences est avantageux. En effet, un gain $g_{dB}$ élevé permet d'avoir une meilleure précision de régulation de la tension $V_{sPAC}$ en sortie de l'amplificateur inverseur de phase AI. De plus, un gain $g_{dB}$ faible permet de limiter le pic de courant $i_d$ en sortie du système de remise à zéro SRZ.

Plus précisément, après l'arrivée d'un signal issu du capteur CAP, pour assurer une décharge du condensateur mémoire $C_m$ qui limite le bruit transitoire, l'élément de contrôle CTL fournit au système de remise à zéro SRZ une fraction de l'écart entre la tension de sortie $V_{sPAC}$ de l'amplificateur inverseur de phase AI et la tension de référence $V_{ref}$. L'élément de contrôle CTL agit donc comme un atténuateur de tension, ce qui limite la valeur maximale atteinte par le courant de décharge $i_d$ par rapport à la situation de l'art antérieur dans laquelle l'écart entre la tension de sortie $V_{sPAC}$ de l'amplificateur inverseur et la tension de référence $V_{ref}$ est directement appliqué avec un gain égal ou supérieur à un. De plus, pour assurer une précision suffisante de régulation statique de la tension en sortie $V_{sPAC}$ de l'amplificateur inverseur de phase AI, c'est-à-dire s'assurer que la tension de sortie $V_{sPAC}$ de l'amplificateur inverseur de phase AI soit voisine de la tension de référence $V_{ref}$ en l'absence de détection, le gain de l'élément de contrôle CTL en basse fréquence augmente quand la fréquence diminue.

L'élément de contrôle CTL permet donc :

- de contrôler la tension de sortie $V_{sPAC}$ de l'amplificateur inverseur de phase AI pour qu'elle soir proche de la tension de référence $V_{ref}$ en régime statique
- de contrôler le courant $i_d$ fourni par le système de remise à zéro SRZ afin de le limiter en régime dynamique.

L'élément de contrôle CTL permet ainsi d'asservir la tension de sortie $V_{sPAC}$ de l'amplificateur inverseur de phase AI à une tension de référence $V_{ref}$ qui, après l'arrivée d'un signal, assure le retour à la tension de référence $V_{ref}$ en réduisant le bruit indissociable de cette opération.

Il existe naturellement une multitude de montages électronique permettant de réaliser un élément de contrôle CTL comportant :

- une première entrée connectée à la sortie S de l'amplificateur inverseur de phase AI, pour prélever le signal de tension $V_{sPAC}$
- une deuxième entrée soumise à une tension de référence $V_{ref}$
- un ensemble de composants configurés et agencés pour générer un signal de contrôle Sg proportionnel à l'écart entre le signal de tension $V_{sPAC}$ et la tension de référence $V_{ref}$, ledit coefficient de proportionnalité étant inférieur à un dans une bande de hautes fréquence
- une sortie connectée au système de remise à zéro SRZ pour lui fournir le signal de contrôle Sg.

L'élément de contrôle CTL présenté à la figure 4 n'en n'est qu'un exemple de réalisation.

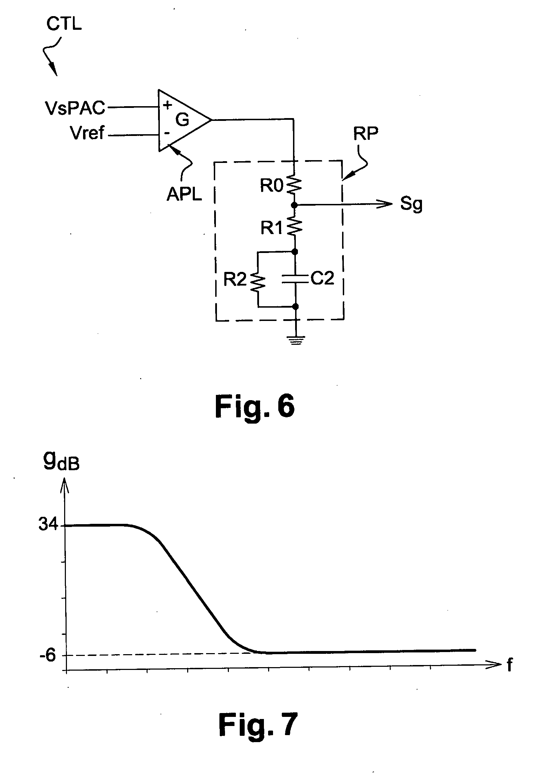

Un deuxième exemple de réalisation est donné à la figure 6. Dans ce deuxième mode de réalisation, l'élément de contrôle CTL comporte :

- un amplificateur opérationnel APL de gain G,

    ◦ une borne non inverseuse soumise au signal de tension $V_{sPAC}$
    ◦ une borne inverseuse soumise à une tension de référence $V_{ref}$
    ◦ une sortie reliée à un réseau passif RP

- le réseau passif RP,

    ◦ une première résistance R0, comportant une première borne connectée à la sortie de l'amplificateur opérationnel APL, et une deuxième borne au niveau de laquelle est prélevé le signal de contrôle Sg
    ◦ une deuxième résistance R1, comportant une première borne connectée à la deuxième borne de la première résistance R0, et une deuxième borne
    ◦ une troisième résistance R2 comprenant une première borne connectée à la deuxième borne de la deuxième résistance R1, et une deuxième borne soumise à une tension nulle
    ◦ un deuxième condensateur C2, monté en parallèle de la deuxième résistance R2.

La fonction de transfert, dans le domaine de Laplace, associée à l'élément de contrôle CTL présenté à la figure 6 est la suivante :

$$H(s) = \frac{Sg}{VsPAC - Vref} = \frac{G(R1 + R2)}{R0 + R1 + R2} \frac{1 + s\dfrac{R1\,R2\,C2}{R1 + R2}}{1 + s\dfrac{(R0 + R1)R2\,C2}{R0 + R1 + R2}}$$

La fonction de transfert comporte un pôle Tp et un zéro Tz, tels que :

7

$$\frac{Tp}{Tz} = \frac{(R0 + R1)(R1 + R2)}{R1(R0 + R1 + R2)}$$

Ce rapport peut prendre des valeurs élevées en fonction des valeurs des résistances. Par exemple, si R1=1Ω, R0=R2=200Ω, alors :

$$\frac{Tp}{Tz} = 100,75$$

En basses fréquences, le gain de cette fonction de transfert tend vers le gain statique :

$$\frac{G(R1 + R2)}{R0 + R1 + R2}$$

En hautes fréquences le gain de cette fonction de transfert tend vers :

$$\frac{G\,R1}{R0 + R1}$$

Le diagramme en gain de Bode de l'élément de contrôle CTL de la figure 6 est représenté à la figure 7, pour les valeurs suivantes : R0 = R2 = 2 GΩ, R1=10 MΩ, C2=10nF et G=100. En basses fréquences, c'est-à-dire en régime statique, c'est-à-dire en l'absence de détection, le gain $g_{dB}$ de l'élément de contrôle est élevé. Dans le cas présent, il est de 34 décibels. Puis, à partir d'une certaine fréquence $f_1$, le gain $g_{dB}$ chute avant de se rétablir à une valeur inférieure à un, dans le cas présent -6 décibels. L'élément de contrôle CTL se comporte donc comme un amplificateur en basses fréquences, et comme un atténuateur dans une bande de fréquences plus élevées.

**Revendications**

1. Préamplificateur de charge (PAC) pour convertir une charge électrique générée dans un capteur (CAP) source de charge en un signal de tension ($V_{sPAC}$), comportant :

   ◦ un amplificateur inverseur de phase (AI) comportant une entrée (E) liée au capteur (CAP) source de charge, et une sortie (S) pour fournir le signal de tension ($V_{sPAC}$)
   ◦ un condensateur mémoire ($C_m$) connecté entre l'entrée (E) et la sortie (S) de l'amplificateur inverseur de phase (AI),
   ◦ un système de remise à zéro (SRZ) du condensateur mémoire ($C_m$), connecté à l'entrée (E) de l'amplificateur inverseur de phase (AI), pour fournir au condensateur mémoire ($C_m$) un courant de décharge ($i_d$) en fonction d'un signal de contrôle (Sg),
   ◦ un élément de contrôle (CTL) adapté pour fournir au système de remise à zéro (SRZ) un signal de contrôle (Sg) proportionnel à l'écart entre le signal de tension ($V_{sPAC}$) et une tension de référence ($V_{ref}$), comportant un amplificateur à transconductance modifié **caractérisé en ce que** ledit élément de contrôle comporte:

   • un élément résistif (R)
   • un premier transistor (MP1) à effet de champ d'un premier type, la grille et le drain du premier transistor (MP1) étant reliés
   • un deuxième transistor (MP2) à effet de champ de même type que le premier transistor (MP1), les sources du premier transistor (MP1) et du deuxième transistor (MP2) étant à un même potentiel fixe, les grilles du premier transistor (MP1) et du deuxième transistor (MP2) étant connectées via l'élément résistif (R)
   • un condensateur (C) connecté entre la grille et le drain du deuxième transistor (MP2)
   • une source de courant continu ($I_0$)
   • un troisième transistor (MN3) à effet de champ de type complémentaire au premier transistor (MP1), tel que :

- le drain du troisième transistor (MN3) est connecté au drain du premier transistor (MP1)
- la source du troisième transistor (MN3) est connectée à la source de courant ($I_0$)
- la grille du troisième transistor (MN3) est soumise à la tension de sortie ($V_{sPAC}$) de l'amplificateur inverseur de phase (AI)

• un quatrième transistor (MN4) à effet de champ de type complémentaire au premier transistor (MP1), tel que :

- le drain du quatrième transistor (MN4) est connecté au drain du deuxième transistor (MP2), et connecté au système de remise à zéro (SRZ) pour lui fournir le signal de contrôle (Sg)
- la source du troisième transistor (MN3) est connectée à la source de courant ($I_0$)
- la grille du troisième transistor (MN3) est soumise à la tension de référence ($V_{ref}$).

2. Un préamplificateur de charge (PAC) selon la revendication précédente, **caractérisé en ce que** l'élément résistif (R) comporte un deuxième amplificateur à transconductance, polarisé par un courant faible.

3. Un préamplificateur de charge (PAC) selon l'une des revendications 1 ou 2, **caractérisé en ce que** l'élément de contrôle (CTL) comporte :

- un amplificateur opérationnel (APL), comportant :

• une borne non inverseuse soumise au signal de tension ($V_{sPAC}$)
• une borne inverseuse soumise à la tension de référence ($V_{ref}$)
• une sortie reliée à un réseau passif (RP)

- le réseau passif (RP),

• une première résistance (R0), comportant une première borne connectée à la sortie de l'amplificateur opérationnel (APL), et une deuxième borne au niveau de laquelle est prélevé le signal de tension (Sg)
• une deuxième résistance (R1), comportant une première borne connectée à la deuxième borne de la première résistance (R0), et une deuxième borne
• une troisième résistance (R2) comprenant une première borne connectée à la deuxième borne de la deuxième résistance (R1), et une deuxième borne soumise à une tension nulle
• un deuxième condensateur (C2), monté en parallèle de la deuxième résistance (R2).

4. Un préamplificateur de charge (PAC) selon l'une des revendications précédentes, **caractérisé en ce que** le système de remise à zéro (SRZ) comporte un transistor à effet de champ dont la source est soumise au signal de contrôle (Sg).

5. Un préamplificateur de charge (PAC) selon l'une des revendications précédentes, **caractérisé en ce que** le système de remise à zéro (SRZ) comporte un transistor bipolaire dont l'émetteur est soumis au signal de contrôle (Sg).

6. Un préamplificateur de charge (PAC) selon l'une des revendications précédentes, **caractérisé en ce que** le système de remise à zéro (SRZ) est polarisé par un courant de fuite du capteur (CAP).

**Patentansprüche**

1. Lastvorverstärker (PAC) zum Konvertieren einer elektrischen Ladung, die in einem Ladungsquellensensor (CAP) generiert wird, in ein Spannungssignal ($V_{sPAC}$), umfassend:

◦ einen Phasenumkehrverstärker (AI), umfassend einen Eingang (E), der mit dem Ladungsquellensensor (CAP) verbunden ist, und einen Ausgang (S), um das Spannungssignal ($V_{sPAC}$) zu liefern,
◦ einen Speicherkondensator (Cm), der zwischen dem Eingang (E) und dem Ausgang (S) des Phasenumkehrverstärkers (AI) angeschlossen ist,
◦ ein Nullrückstellungssystem (SRZ) des Speicherkondensators ($C_m$), der an den Eingang (E) des Phasenumkehrverstärkers (AI) angeschlossen ist, um dem Speicherkondensator ($C_m$) einen Entladungsstrom ($i_d$) in Abhängigkeit von einem Steuersignal (Sg) zu liefern,

○ ein Steuerelement (CTL), das angepasst ist, um dem Nullrückstellungssystem (SRZ) ein Steuersignal (Sg) zu liefern, das proportional zur Beabstandung zwischen dem Spannungssystem ($V_{sPAC}$) und einer Referenzspannung ($V_{ref}$) ist, umfassend einen Verstärker mit modifizierter Steilheit, **dadurch gekennzeichnet, dass** das genannte Steuerelement umfasst:

- ein ohmsches Element (R)
- einen ersten Transistor (MP1) mit Feldwirkung eines ersten Typs, wobei das Gitter und die Abzugselektrode des ersten Transistors (MP1) miteinander verbunden sind
- einen zweiten Transistor (MP2) mit Feldwirkung desselben Typs wie der erste Transistor (MP1), wobei die Quellen des ersten Transistors (MP1) und des zweiten Transistors (MP2) ein und dasselbe feste Potenzial haben, wobei die Gitter des ersten Transistors (MP1) und des zweiten Transistors (MP2) über das ohmsche Element (R) angeschlossen sind
- einen Kondensator (C), der zwischen dem Gitter und der Abzugselektrode des zweiten Transistors (MP2) angeschlossen ist
- eine Gleichspannungsquelle ($I_0$)
- einen dritten Transistor (MN3) mit Feldwirkung vom zum ersten Transistor (MP1) komplementären Typ, wie z. B.:

 - die Abzugselektrode des dritten Transistors (MN3) ist an die Abzugselektrode des ersten Transistors (MP1) angeschlossen
 - die Quelle des dritten Transistors (MN3) ist an die Stromquelle ($I_0$) angeschlossen
 - das Gitter des dritten Transistors (MN3) ist der Ausgangsspannung ($V_{sPAC}$) des Phasenumkehrverstärkers (AI) unterworfen

- einen vierten Transistor (MN4) mit Feldwirkung vom zum ersten Transistor (MP1) komplementären Typ, wie z. B.:

 - die Abzugselektrode des vierten Transistors (MN4) ist an die Abzugselektrode des zweiten Transistors (MP2) angeschlossen und ist an das Nullrückstellungssystem (SRZ) angeschlossen, um ihm das Steuersignal (Sg) zu liefern
 - die Quelle des dritten Transistors (MN3) ist an die Stromquelle ($I_0$) angeschlossen
 - das Gitter des dritten Transistors (MN3) ist der Referenzspannung ($V_{ref}$) unterworfen.

2. Lastvorverstärker (PAC) gemäß dem voranstehenden Anspruch, **dadurch gekennzeichnet, dass** das ohmsche Element (R) einen zweiten Verstärker mit Steilheit umfasst, der durch einen Schwachstrom polarisiert ist.

3. Lastvorverstärker (PAC) gemäß Anspruch 1 oder 2, **dadurch gekennzeichnet, dass** das Steuerelement (CTL) umfasst:

- einen betrieblichen Verstärker (APL), umfassend:

 - eine Nicht-Umkehranschlussklemme, die dem Spannungssignal ($V_{sPAC}$) unterworfen ist
 - eine Umkehranschlussklemme, die der Referenzspannung ($V_{ref}$) unterworfen ist
 - einen an ein passives Netz (RP) angeschlossenen Ausgang

- wobei das passive Netz (RP) umfasst:

 - einen ersten Widerstand (R0), umfassend eine erste Anschlussklemme, die an den Ausgang des betrieblichen Verstärkers (APL) angeschlossen ist, und eine zweite Anschlussklemme, an der das Spannungssignal (Sg) abgenommen wird
 - einen zweiten Widerstand (R1), umfassend eine erste Anschlussklemme, die an die zweite Anschlussklemme des ersten Widerstandes (R0) angeschlossen ist, und eine zweite Anschlussklemme
 - einen dritten Widerstand (R2), umfassend eine erste Anschlussklemme, die an die zweite Anschlussklemme des zweiten Widerstandes (R1) angeschlossen ist, und eine zweite Anschlussklemme, die einer Nullspannung unterworfen ist
 - einen zweiten Kondensator (C2), der parallel zu dem zweiten Widerstand (R2) montiert ist.

4. Lastvorverstärker (PAC) gemäß einem der voranstehenden Ansprüche, **dadurch gekennzeichnet, dass** das Nullrückstellungssystem (SRZ) einen Transistor mit Feldwirkung umfasst, dessen Quelle dem Steuersignal (Sg) unterliegt.

5. Lastvorverstärker (PAC) gemäß einem der voranstehenden Ansprüche, **dadurch gekennzeichnet, dass** das Nullrückstellungssystem (SRZ) einen bipolaren Transistor umfasst, dessen Sender dem Steuersignal (SG) unterworfen ist.

6. Lastvorverstärker (PAC) gemäß einem der voranstehenden Ansprüche, **dadurch gekennzeichnet, dass** das Nullrückstellungssystem (SRZ) durch einen Kriechstrom des Sensors (CAP) polarisiert ist.

**Claims**

1. Charge preamplifier (PAC) for converting an electrical charge generated in a sensor (CAP) charging source into a voltage signal ($V_{sPAC}$) comprising:

    ◦ a phase inverting amplifier (AI) comprising an input (E) connected to the sensor (CAP) charging source, and an output (S) for supplying the voltage signal ($V_{sPAC}$)
    ◦ a memory capacitor ($C_m$) connected between the input (E) and the output (S) of the phase inverting amplifier (AI),
    ◦ a reset system (SRZ) of the memory capacitor ($C_m$), connected to the input (E) of the phase inverting amplifier (AI), to provide the memory capacitor ($C_m$) with a discharge current ($i_d$) according to a control signal (Sg),
    ◦ a control member (CTL) adapted to provide the reset system (SRZ) with a control signal (Sg) proportional to the difference between the voltage signal ($V_{sPAC}$) and a reference voltage ($V_{ref}$), comprising a modified transconductance amplifier **characterised in that** said control member comprises:

    • a resistive element (R)
    • a first field effect transistor (MP1) of a first type, with the gate and the drain of the first transistor (MP1) being connected
    • a second field effect transistor (MP2) of the same type as the first transistor (MP1), with the sources of the first transistor (MP1) and of the second transistor (MP2) being at the same fixed potential, the gates of the first transistor (MP1) and of the second transistor (MP2) being connected via the resistive element (R)
    • a capacitor (C) connected between the gate and the drain of the second transistor (MP2)
    • a source of direct current ($I_0$)
    • a third field effect transistor (MN3) of a type complementary to the first transistor (MP1), such that:

        - the drain of the third transistor (MN3) is connected to the drain of the first transistor (MP1)
        - the source of the third transistor (MN3) is connected to the source of current ($I_0$)
        - the gate of the third transistor (MN3) is subjected to the output voltage ($V_{sPAC}$) of the phase inverting amplifier (AI)

    • a fourth field effect transistor (MN4) of a type complementary to the first transistor (MP1), such that:

        - the drain of the fourth transistor (MN4) is connected to the drain of the second transistor (MP2), and connected to the reset system (SRZ) in order to provide it the control signal (Sg)
        - the source of the third transistor (MN3) is connected to the source of current ($I_0$)
        - the gate of the third transistor (MN3) is subjected to the reference voltage ($V_{ref}$).

2. Charge preamplifier (PAC) as claimed in the preceding claim, **characterised in that** the resistive element (R) comprises a second transconductance amplifier, polarised for a low current.

3. Charge preamplifier (PAC) according to one of claims 1 or 2, **characterised in that** the control member (CTL) comprises:

    - an operational amplifier (APL), comprising:

        • a non-inverting terminal subjected to the voltage signal ($V_{sPAC}$)
        • an inverting terminal subjected to the reference voltage ($V_{ref}$)

• an output connected to a passive network (RP)

- the passive network (RP), comprising:

• a first resistor (R0), comprising a first terminal connected to the output of the operational amplifier (APL), and a second terminal at the level of which the signal voltage is taken (Sg)
• a second resistor (R1), comprising a first terminal connected to the second terminal of the first resistor (R0), and a second terminal
• a third resistor (R2) comprising a first terminal connected to the second terminal of the second resistor (R1), and a second terminal subjected to a zero voltage
• a second capacitor (C2), mounted in parallel of the second resistor (R2).

4. Charge preamplifier (PAC) according to one of the preceding claims, **characterised in that** the reset system (SRZ) comprises a field effect transistor of which the source is subjected to the control signal (Sg).

5. Charge preamplifier (PAC) according to one of the preceding claims, **characterised in that** the reset system (SRZ) comprises a bipolar transistor of which the issuer is subjected to the control signal (Sg).

6. Charge preamplifier (PAC) according to one of the preceding claims, **characterised in that** the reset system (SRZ) is polarised by a leakage current of the sensor (CAP).

$$Vm = -\frac{qc}{Cm}$$

**Fig. 1**

**Fig. 2**

**Fig. 3**

**Fig. 4**

**Fig. 5**

## Fig. 6

## Fig. 7

**RÉFÉRENCES CITÉES DANS LA DESCRIPTION**

**Documents brevets cités dans la description**

- US 476035 A
- US 5523642 A